# EUROPEAN PATENT SPECIFICATION

(11) **EP 2 435 516 B1**
(45) Date of publication and mention of the grant of the patent: **22.03.2017**
(21) Application number: 10706853.8
(22) Date of filing: 25.02.2010
(51) Int. Cl.: C08L 83/04, H01L 23/29, C08L 83/05, C08L 83/07

(54) **SILICONE COMPOSITION FOR PRODUCING TRANSPARENT SILICONE MATERIALS AND OPTICAL DEVICES**
SILIKONZUSAMMENSETZUNG ZUR HERSTELLUNG VON TRANSPARENTEN SILIKONMATERIALIEN UND OPTISCHEN VORRICHTUNGEN
COMPOSITION DE SILICONE POUR PRODUIRE DES MATÉRIAUX DE SILICONE TRANSPARENTS ET DES DISPOSITIFS OPTIQUES

(30) Priority: 29.05.2009 US 182128 P
(43) Date of publication of application: 04.04.2012
(73) Proprietor: Dow Corning Corporation, Midland, Michigan 48686-0994 (US)
(72) Inventor: BAHADUR, Maneesh, Midland MI 48642 (US); NELSON, Robert, Bay City MI 48706 (US); STRONG, Michael, Midland MI 48640 (US)
(74) Representative: Earnshaw, Geoffrey Mark
(86) International application number: PCT/US2010/025302
(87) International publication number: WO 2010/138221

(56) References cited:
- EP-A1- 0 997 498
- EP-A2- 0 955 328
- WO-A1-2004/005404
- WO-A1-2007/026727
- US-A1- 2007 106 016

## Description

### BACKGROUND OF THE INVENTION

### Technical Field

A silicone composition, and cured product thereof, is useful in optical devices such as charged coupled devices (CCDs), light emitting diodes (LEDs), lightguides, optical cameras, photo-couplers, and waveguides. Processes for fabricating the optical devices include various molding techniques. The composition contains a combination of high and low viscosity linear polyorganosiloxanes and a low vinyl content silicone resin.

### Background

LEDs may provide the benefits of reduced size and reduced energy usage as compared to incandescent bulbs. In addition, LEDs may have longer life than incandescent bulbs. LEDs, particularly high brightness LEDs (HB LEDs), are useful in applications where the HB LEDs are recessed from a viewing surface because LEDs have high lumen output. Such applications include backlighting units for displays, automotive lamp applications, (*e.g*., headlamps and tail lamps), and message board applications.

Lightguides are used with the HB LEDs to transmit light to the viewing surface. Lightguides may have various sizes and shapes, such as a flat or planar shape for homogenous illumination of a wide area, or a pipe design for illuminating a smaller well defined area.

LEDs can generate both high thermal flux and high optical flux. Conventional organic lightguides and LED packages, such as those fabricated from polymethyl methacrylate (PMMA), polycarbonate (PC), or cyclo olefin copolymer (COC) used in conjunction with LEDs may suffer from the drawback of insufficient stability when exposed to heat and/or radiation; ultra-violet (UV) and/or visible radiation. Organic lightguides may suffer from loss of transmittance during the lifetime of the device in which the lightguide is used. There is a continuing need in the optoelectronics industry for transparent materials with desirable physical properties for various optical device applications.

EP-0997498A1 and EP-0955328A2 describe various silicone compositions prepared by mixing polyorganosiloxanes with different viscosities to provide either silicone elastomers possessing particular rheological properties for particular applications, being a chip scale package, or which provide cured products which exhibit low outgassing during vacuum dispensing.

### SUMMARY OF THE INVENTION

Use of a cured product of a composition which contains a combination of high and low viscosity polyorganosiloxanes, a low vinyl content silicone resin, a crosslinker, and a catalyst as defined in Claim 1, in an optical device application, or in an optical device as listed in Claim 2.

### BRIEF DESCRIPTION OF THE DRAWINGS

Figures 1a, 1b, and 1c show different configurations for a lightguide made with the silicone composition described herein.
Figure 2 shows an LED package containing the cured product of the silicone composition described herein.

### Reference Numerals

- 101: LED
- 102: lightguide
- 103: inlet of the lightguide
- 104: organic lightguide
- 105: outlet of the lightguide
- 106: optical coupling agent
- 107: clad
- 108: surface of the lightguide
- 201: dome
- 202: wire
- 203: soft silicone
- 204: LED chip
- 205: lead frame

### DETAILED DESCRIPTION OF THE INVENTION

All amounts, ratios, and percentages are by weight unless otherwise indicated. The following is a list of definitions as used in this application.

### Definitions

The articles "a", "an" and "the" each refer to one or more.

The abbreviation "M" means a siloxane unit of formula R₃SiO_{1/2}, where each R independently represents a monovalent atom or group.

The abbreviation "D" means a siloxane unit of formula R₂SiO_{2/2}, where each R independently represents a monovalent atom or group.

The abbreviation "T" means a siloxane unit of formula RSiO_{3/2}, where R represents a monovalent atom or group.

The abbreviation "Q" means a siloxane unit of formula SiO_{4/2}.

The abbreviation "Me" represents a methyl group.

The abbreviation "Ph" represents a phenyl group.

The abbreviation "Vi" represents a vinyl group.

"Combination" means two or more items put together by any method.

A "lightguide" means a shaped article that carries light from a point-like light source, such as an LED, to a target such as a target line or target plane by internal reflection.

A "silylated acetylenic inhibitor" means any reaction product of an acetylenic alcohol inhibitor and a silane.

"Unsubstituted hydrocarbon group" means a group made up of hydrogen and carbon atoms.

"Substituted hydrocarbon group" means a group made up of hydrogen and carbon atoms, except that at least one hydrogen atom has been replaced with a different substituent atom or group such as a halogen atom, halogenated organic group, or a cyano group.

### Composition

The composition is hydrosilylation curable to form a cured product. The composition comprises:
(A) a polymer combination comprising
   (A1) a low viscosity polydiorganosiloxane having an average of at least two aliphatically unsaturated organic groups per molecule and having a viscosity of up to 12,000 mPa·s, and
   (A2) a high viscosity polydiorganosiloxane having an average of at least two aliphatically unsaturated organic groups per molecule and having a viscosity of at least 45,000 mPa·s;
(B) a silicone resin having an average of at least two aliphatically unsaturated organic groups per molecule;
(C) a crosslinker having an average, per molecule, of at least two silicon bonded hydrogen atoms; and
(D) a hydrosilylation catalyst;
with the proviso that when the ingredients and their amounts in the composition are selected such that a ratio of a total amount of silicon bonded hydrogen atoms in the composition/ a total amount of aliphatically unsaturated organic groups in the composition (SiH/Vi ratio) ranges from 1.2 to 1.7, alternatively 1.5, the cured product has Shore A hardness of at least 30, tensile strength of at least 3 MPa and elongation at break of at least 50%.

### Ingredient (A) Polymer Combination

Ingredient (A) is a polymer combination. The polymers comprise aliphatically unsaturated polydiorganosiloxanes that differ in viscosity. The polymer combination comprises:
(A1) a low viscosity polydiorganosiloxane having an average of at least two aliphatically unsaturated organic groups per molecule and having a viscosity of up to 12,000 mPa·s, and
(A2) a high viscosity polydiorganosiloxane having an average of at least two aliphatically unsaturated organic groups per molecule and having a viscosity of at least 45,000 mPa·s.

The aliphatically unsaturated organic groups in ingredient (A) may be alkynyl exemplified by, but not limited to, vinyl, allyl, butenyl, pentenyl, and hexenyl; alternatively vinyl. The aliphatically unsaturated organic groups may be alkynyl groups exemplified by, but not limited to, ethynyl, propynyl, and butynyl. The aliphatically unsaturated organic groups in ingredient (A) may be located at terminal, pendant, or both terminal and pendant positions. Alternatively, the aliphatically unsaturated organic groups in ingredient (A) may be located at terminal positions of the polydiorganosiloxanes.

The remaining silicon-bonded organic groups in the polydiorganosiloxanes of ingredient (A) may be monovalent organic groups, which are substituted and unsubstituted hydrocarbon groups free aliphatic unsaturation. Monovalent unsubstituted hydrocarbon groups are exemplified by, but not limited to alkyl groups such as methyl, ethyl, propyl, pentyl, octyl, undecyl, and octadecyl; cycloalkyl groups such as cyclohexyl; and aromatic groups such as ethylbenzyl, naphthyl, phenyl, tolyl, xylyl, benzyl, styryl, 1-phenylethyl, and 2-phenylethyl, alternatively phenyl. Monovalent substituted hydrocarbon groups are exemplified by, but not limited to halogenated alkyl groups such as chloromethyl, 3-chloropropyl, and 3,3,3-trifluoropropyl, fluoromethyl, 2-fluoropropyl, 3,3,3-trifluoropropyl, 4,4,4-trifluorobutyl, 4,4,4,3,3-pentafluorobutyl, 5,5,5,4,4,3,3-heptafluoropentyl, 6,6,6,5,5,4,4,3,3-nonafluorohexyl, and 8,8,8,7,7-pentafluorooctyl.

The polydiorganosiloxanes for ingredients (A1) and (A2) each have an average per molecule of at least two aliphatically unsaturated organic groups. Ingredient (A1) can be a single polydiorganosiloxane or a combination comprising two or more polydiorganosiloxanes that differ in at least one of the following properties: structure, average molecular weight, siloxane units, and sequence. The viscosity of ingredient (A1) is up to 12,000 mPa·s. Alternatively, the viscosity of ingredient (A1) may range from 300 mPa·s to 12,000 mPa·s, alternatively 300 mPa·s to 2,500 mPa·s, and alternatively 300 mPa·s to 2,000 mPa·s. The amount of ingredient (A1) in the composition may range from 10% to 90%, alternatively 70% to 80%, based on the combined weight of ingredient (A).

Ingredient (A1) may have general formula (I): R¹₃SiO-(R²₂SiO)ₐ-SiR¹₃, where each R¹ and each R² are independently selected from the group consisting of aliphatically unsaturated organic groups and monovalent organic groups such as the substituted and unsubstituted hydrocarbon groups described above, and subscript a is an integer having a value sufficient to provide ingredient (A) with a viscosity up to 12,000 mPa·s, with the proviso that on average at least two of R¹ and/or R² are unsaturated organic groups. Alternatively, formula (I) may be an α,ω-dialkenyl-functional polydiorganosiloxane.

Ingredient (A2) can be a single polydiorganosiloxane or a combination comprising two or more polydiorganosiloxanes that differ in at least one of the following properties: structure, average molecular weight, siloxane units, and sequence. The viscosity of ingredient (A2) is at least 45,000 mPa·s. Alternatively, the viscosity of ingredient (A2) may range from 45,000 to 65,000 mPa·s. The amount of ingredient (A2) in the composition may range from 10% to 90%, alternatively 20% to 30%, parts by weight based on the combined weight of the polymers in ingredient (A).

Ingredient (A2) may have general formula (II): R³_{S}iO-(R⁴₂SiO)_{b}-SiR³₃, where each R³ and each R⁴ are independently selected from the group consisting of aliphatically unsaturated organic groups and monovalent organic groups such as the substituted and unsubstituted hydrocarbon groups described above, and subscript b is an integer having a value sufficient to provide ingredient (A) with a viscosity of at least 45,000 mPa·s, alternatively 45,000 mPa·s to 65,000 mPa·s, with the proviso that on average at least two of R³ and/or R⁴ are unsaturated organic groups. Alternatively, formula (II) may be an α,ω-dialkenyl-functional polydiorganosiloxane.

### Ingredient (B) Silicone Resin

The silicone resin useful herein contains an average of at least two aliphatically unsaturated organic groups per molecule. The amount of aliphatically unsaturated organic groups in the resin may be up to 3.0% based on the weight of the silicone resin. Alternatively, the amount of aliphatically unsaturated organic groups in the silicone resin may range from 1.9% to 3.0%, alternatively 2.0% to 3.0%, alternatively 1.5% to 3.0%, alternatively 1.9% to 3.0%, and alternatively 1.5% to 2.0% on the same basis. The silicone resin comprises monofunctional (M) units represented by R⁵₃SiO_{1/2} and tetrafunctional (Q) units represented by SiO_{4/2}. R⁵ represents a monovalent organic group, which is a substituted or unsubstituted monovalent hydrocarbon group. The silicone resin is soluble in liquid hydrocarbons such as benzene, toluene, xylene, heptane and the like or in liquid organosilicon compounds such as low viscosity cyclic and linear polydiorganosiloxanes. Examples include the solvents described below.

In the R⁵₃SiO_{1/2} unit, R⁵ may be a monovalent unsubstituted hydrocarbon group, exemplified by alkyl groups such as methyl, ethyl, propyl, pentyl, octyl, undecyl, and octadecyl; alkenyl groups, such as vinyl, allyl, butenyl, pentenyl and hexenyl; cycloaliphatic radicals, such as cyclohexyl and cyclohexenylethyl; alkynyl groups such as, ethynyl, propynyl, and butynyl; cycloalkyl groups such as cyclopentyl and cyclohexyl; and aromatic groups such as ethylbenzyl, naphthyl, phenyl, tolyl, xylyl, benzyl, styryl, 1-phenylethyl, and 2-phenylethyl, alternatively phenyl. Non-reactive substituents that can be present on R⁵ include but are not limited to halogen and cyano. Monovalent organic groups which are substituted hydrocarbon groups are exemplified by, but not limited to halogenated alkyl groups such as chloromethyl, 3-chloropropyl, and 3,3,3-trifluoropropyl, fluoromethyl, 2-fluoropropyl, 3,3,3-trifluoropropyl, 4,4,4-trifluorobutyl, 4,4,4,3,3-pentafluorobutyl, 5,5,5,4,4,3,3-heptafluoropentyl, 6,6,6,5,5,4,4,3,3-nonafluorohexyl, and 8,8,8,7,7-pentafluorooctyl.

The silicone resin may have a ratio of M units to Q units (M:Q ratio) ranging from 0.6:1 to 1.1:1. The silicone resin may have a number average molecular weight ranging from 2,000 to 5,000, see U.S. Patent 6,124,407 for a description of suitable silicone resins and how to prepare them.

The silicone resin can be prepared by any suitable method. Silicone resins of this type have reportedly been prepared by cohydrolysis of the corresponding silanes or by silica hydrosol capping methods known in the art. The silicone resin may be prepared by the silica hydrosol capping processes of Daudt, et al., U.S. Patent 2,676,182; of Rivers-Farrell et al., U.S. Patent 4,611,042; of Butler, U.S. Patent 4,774,310; and of Lee, et al., U.S. Patent 6,124,407.

The intermediates used to prepare the silicone resin are typically triorganosilanes of the formula R⁵₃SiX', where R⁵ is as described above and X' represents a hydrolyzable group, and either a silane with four hydrolyzable groups, such as halogen, alkoxy or hydroxyl, or an alkali metal silicate such as sodium silicate.

It is desirable that the content of silicon-bonded hydroxyl groups (*i.e*., HOSiO_{3/2} groups) in the silicone resin be below 0.7 % of the total weight of the silicone resin, alternatively below 0.3 %. Silicon-bonded hydroxyl groups formed during preparation of the silicone resin may be converted to trihydrocarbylsiloxy groups or hydrolyzable groups by reacting the silicone resin with a silane, disiloxane or disilazane containing the appropriate terminal group. Silanes containing hydrolyzable groups are typically added in excess of the quantity required to react with the silicon-bonded hydroxyl groups of the silicone resin.

The silicone resin may be one silicone resin. Alternatively, the silicone resin may comprise two or more silicone resins, where the resins differ in at least one of the following properties: structure, hydroxyl and/or hydrolyzable group content, molecular weight, siloxane units, and sequence. The amount of silicone resin in the composition may vary depending on the type and amounts of polymers present, and the aliphatically unsaturated organic groups (*e.g.,* vinyl) content of ingredients (A) and (B), however, the amount of silicone resin may range from 25 % to 40%, alternatively 26% to 38%, by weight of the composition.

### Ingredient (C) Crosslinker

Ingredient (C) is a crosslinker having an average, per molecule, of at least two silicon bonded hydrogen atoms. Ingredient (C) may comprise a polyorganohydrogensiloxane. Ingredient (C) can be a single polyorganohydrogensiloxane or a combination comprising two or more polyorganohydrogensiloxanes that differ in at least one of the following properties: structure, viscosity, average molecular weight, siloxane units, and sequence.

Ingredient (C) may comprise a linear polyorganohydrogensiloxane of general formula (III): HR⁶₂SiO-(R⁶₂SiO)_{c}-SiR⁶₂H, where each R⁶ is independently a hydrogen atom, or a monovalent organic group, which is a monovalent substituted or unsubstituted hydrocarbon group as exemplified above for R⁵, with the proviso that on average at least two R⁶ per molecule are hydrogen atoms, and subscript c is an integer with a value of 1 or more. Alternatively, at least three R⁶ per molecule are hydrogen atoms and c may range from 1 to 20, alternatively 1 to 10. Ingredient (C) may comprise a hydrogen terminated polydiorganosiloxane. Alternatively, ingredient (C) may comprise a poly(dimethyl/methylhydrogen)siloxane copolymer.

Alternatively, ingredient (C) may comprise a branched polyorganohydrogensiloxane of unit formula (IV): (R⁷SiO_{3/2})_{d}(R⁷₂SiO_{2/2})ₑ(R⁷₃SiO_{1/2})_{f}(SiO_{4/2})_{g}(X'O)ₕ where X' is an alkoxy-functional group. Each R⁷ is independently a hydrogen atom or a monovalent organic group, which is a monovalent substituted or unsubstituted hydrocarbon group as exemplified above for R⁵, with the proviso that an average of at least two per molecule of R⁷ are hydrogen atoms. In formula (IV), the polyorganohydrogensiloxane contains an average of at least two silicon bonded hydrogen atoms per molecule, however, 0.1 mol% to 40 mol% of R⁷ may be hydrogen atoms.

In formula (IV), subscript d is a positive number, subscript e is 0 or a positive number, subscript f is 0 or a positive number, subscript g is 0 or a positive number, subscript h is 0 or a positive number, e/d has a value ranging from 0 to 10, f/e has a value ranging from 0 to 5, g/(d+e+f+g) has a value ranging from 0 to 0.3, and h/(d+e+f+g) has a value ranging from 0 to 0.4.

The amount of ingredient (C) added is sufficient to provide the SiH/Vi ratio in the range described above.

### Ingredient (D) Hydrosilylation Catalyst

Ingredient (D) is a hydrosilylation catalyst. Ingredient (D) is added in an amount sufficient to promote curing of the composition. However, the amount of ingredient (D) may range from 0.01 to 1,000 ppm, alternatively 0.01 to 100 ppm, and alternatively 0.01 to 50 ppm, alternatively 1 to 18 ppm, and alternatively 1 to 7 ppm, of platinum group metal based on the weight of this silicone composition.

Suitable hydrosilylation catalysts are known in the art and commercially available. Ingredient (D) may comprise a platinum group metal selected from the group consisting of platinum, rhodium, ruthenium, palladium, osmium or iridium metal or organometallic compound thereof, and a combination thereof. Ingredient (D) is exemplified by platinum black, compounds such as chloroplatinic acid, chloroplatinic acid hexahydrate, a reaction product of chloroplatinic acid and a monohydric alcohol, platinum bis-(ethylacetoacetate), platinum bis-(acetylacetonate), platinum dichloride, and complexes of said compounds with olefins or low molecular weight organopolysiloxanes or platinum compounds microencapsulated in a matrix or coreshell type structure. Complexes of platinum with low molecular weight organopolysiloxanes include 1,3-diethenyl-1,1,3,3-tetramethyldisiloxane complexes with platinum. These complexes may be microencapsulated in a resin matrix. Alternatively, the catalyst may comprise 1,3-diethenyl-1,1,3,3-tetramethyldisiloxane complex with platinum.

Suitable hydrosilylation catalysts for ingredient (D) are described in, for example, U.S. Patents 3,159,601; 3,220,972; 3,296,291; 3,419,593; 3,516,946; 3,814,730; 3,989,668; 4,784,879; 5,036,117; and 5,175,325 and EP 0 347 895 B. Microencapsulated hydrosilylation catalysts and methods of preparing them are also known in the art, as exemplified in U.S. Patent No. 4,766,176; and U.S. Patent No. 5,017,654.

### Additional Ingredients

The composition described above may further comprise an additional ingredient. Suitable additional ingredients include, but are not limited to (E) an inhibitor, (F) a mold release agent, (G) an optically active agent, (H) a filler, (I) an adhesion promoter, (J) a heat stabilizer, (K) a flame retardant, (L) a reactive diluent, (M) a pigment, (N) a flame retarder, (O) an oxidation inhibitor, and a combination thereof.

### Ingredient (E) Inhibitor

Ingredient (E) is an inhibitor. Suitable inhibitors are exemplified by acetylenic alcohols, cycloalkenylsiloxanes, ene-yne compounds, triazoles, phosphines; mercaptans; hydrazines; amines, and combinations thereof. Suitable acetylenic alcohols are exemplified by methyl butynol, ethynyl cyclohexanol, dimethyl hexynol, 3,5-dimethyl-1-hexyn-3-ol, and a combination thereof; cycloalkenylsiloxanes such as methylvinylcyclosiloxanes exemplified by 1,3,5,7-tetramethyl-1,3,5,7-tetravinylcyclotetrasiloxane, 1,3,5,7-tetramethyl-1,3,5,7-tetrahexenylcyclotetrasiloxane, and a combination thereof; ene-yne compounds such as 3-methyl-3-penten-1-yne, 3,5-dimethyl-3-hexen-1-yne; triazoles such as benzotriazole; phosphines; mercaptans; hydrazines; amines such as tetramethyl ethylenediamine, dialkyl fumarates, dialkenyl fumarates, dialkoxyalkyl fumarates, maleates such as diallyl maleate, and a combination thereof. Suitable inhibitors are disclosed by, for example, U.S. Patents 3,445,420; 3,989,667; 4,584,361; and 5,036,117. Alternatively, ingredient (E) may comprise an organic acetylenic alcohol, a silylated acetylenic alcohol, or a combination thereof. Examples of organic acetylenic alcohol inhibitors are disclosed, for example, in EP 0 764 703 A2 and U.S. Patent 5,449,802 and include 1-butyn-3-ol, 1-propyn-3-ol, 2-methyl-3-butyn-2-ol, 3-methyl-1-butyn-3-ol, 3-methyl-1-pentyn-3-ol, 3-phenyl-1-butyn-3-ol, 4-ethyl-1-octyn-3-ol, 3,5-dimethyl-1-hexyn-3-ol, and 1-ethynyl-1-cyclohexanol. Alternatively, ingredient (E) in the composition may be a silylated acetylenic inhibitor. Without wishing to be bound by theory, it is thought that adding a silylated acetylenic inhibitor may reduce yellowing of the cured product prepared from the composition as compared to a cured product prepared from a hydrosilylation curable composition that does not contain an inhibitor or that contains an organic acetylenic alcohol inhibitor. The silicone composition may be free of organic acetylenic alcohol inhibitors. "Free of organic acetylenic alcohol inhibitors" means that if any organic acetylenic alcohol is present in the composition, the amount present is insufficient to reduce optical transparency of the cured product to < 95 % at a thickness of 2.0 mm or less at 400 nm wavelength after heating at 200 °C for 14 days.

Ingredient (E) may be added in an amount ranging from 0.001 to 1 parts by weight based on the total weight of the composition, alternatively 0.01 to 0.5 parts by weight. Suitable silylated acetylenic inhibitors for ingredient (E) may have general formula (V): 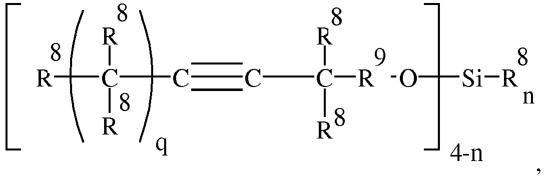 or
general formula (VI): 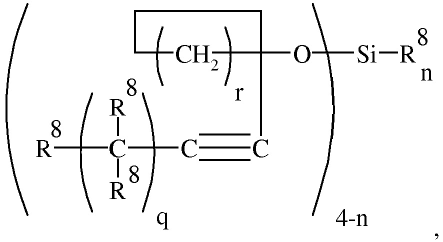 or a combination thereof;
where each R⁸ is independently a hydrogen atom or a monovalent organic group, and subscript n is 0, 1, 2, or 3, subscript q is 0 to 10, and subscript r is 4 to 12. Alternatively n is 1 or 3. Alternatively, in general formula (V), n is 3. Alternatively, in general formula (VI), n is 1. Alternatively q is 0. Alternatively, r is 5, 6, or 7, and alternatively r is 6. Examples of monovalent organic groups for R⁸ include an aliphatically unsaturated organic group, an aromatic group, or a monovalent organic group, which is a monovalent substituted or unsubstituted hydrocarbon group free of aromatics and free aliphatic unsaturation, as described above. R⁹ is a covalent bond or a divalent hydrocarbon group.

Silylated acetylenic inhibitors are exemplified by (3-methyl-1-butyn-3-oxy)trimethylsilane, ((1,1-dimethyl-2-propynyl)oxy)trimethylsilane, bis(3-methyl-1-butyn-3-oxy)dimethylsilane, bis(3-methyl-1-butyn-3-oxy)silanemethylvinylsilane, bis((1,1-dimethyl-2-propynyl)oxy)dimethylsilane, methyl(tris(1,1-dimethyl-2-propynyloxy))silane, methyl(tris(3-methyl-1-butyn-3-oxy))silane, (3-methyl-1-butyn-3-oxy)dimethylphenylsilane, (3-methyl-1-butyn-3-oxy)dimethylhexenylsilane, (3-methyl-1-butyn-3-oxy)triethylsilane, bis(3-methyl-1-butyn-3-oxy)methyltrifluoropropylsilane, (3,5-dimethyl-1-hexyn-3-oxy)trimethylsilane, (3-phenyl-1-butyn-3-oxy)diphenylmethylsilane, (3-phenyl-1-butyn-3-oxy)dimethylphenylsilane, (3-phenyl-1-butyn-3-oxy)dimethylvinylsilane, (3-phenyl-1-butyn-3-oxy)dimethylhexenylsilane, (cyclohexyl-1-ethyn-1-oxy)dimethylhexenylsilane, (cyclohexyl-1-ethyn-1-oxy)dimethylvinylsilane, (cyclohexyl-1-ethyn-1-oxy)diphenylmethylsilane, (cyclohexyl-1-ethyn-1-oxy)trimethylsilane, and combinations thereof. Alternatively, ingredient (E) is exemplified by methyl(tris(1,1-dimethyl-2-propynyloxy))silane, ((1,1-dimethyl-2-propynyl)oxy)trimethylsilane, or a combination thereof.

The silylated acetylenic inhibitor may be prepared by methods known in the art for silylating an alcohol such as reacting a chlorosilane of formula R⁶ₙSiCl₄₋ₙ with an acetylenic alcohol of formula 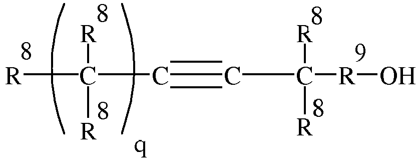 or 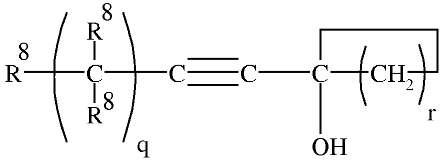 in the presence of an acid receptor. In these formulae, n, q, r, and R⁸ are as described above and R⁹ is a covalent bond or a divalent hydrocarbon group. Examples of silylated acetylenic inhibitors and methods for their preparation are disclosed, for example, in EP 0 764 703 A2 and U.S. Patent 5,449,802.

### Ingredient (F) Mold Release Agent

Ingredient (F) is an optional mold release agent. Ingredient (F) may have general formula (VI): R¹⁰₃SiO(R¹⁰₂SiO)ᵢ(R¹⁰R¹¹SiO)ⱼSiR¹⁰₃, where each R¹⁰ is independently a hydroxyl group or a monovalent organic group, and each R¹¹ is independently a monovalent organic group unreactive with aliphatically unsaturated organic groups and silicon-bonded hydrogen atoms in the composition, subscript i has a value of 0 or greater, subscript j has a value of 1 or greater with the proviso that i and j have may have values sufficient that the mold release agent has a viscosity of 50 to 3,000 mPa·s at molding process temperatures. Alternatively, each R¹⁰ may independently be an alkyl group such as methyl, ethyl, propyl, or butyl or an alkoxy group such as methoxy, ethoxy, propoxy, or butoxy, and each R¹¹ may independently be an aromatic group such as phenyl, tolyl, or xylyl. Alternatively each R¹⁰ may be methyl and each R¹¹ may be phenyl. Examples of suitable mold release agents include trimethylsiloxy-terminated (dimethylsiloxane/phenylmethylsiloxane) copolymer having a viscosity of 100 to 500 mPa·s at 25 °C.

Alternatively, ingredient (F) may comprise an α,ω-dihydroxy-functional polydiorganosiloxane that may be added to the composition in an amount ranging from 0 % to 5 %, alternatively 0.25 % to 2 % based on the weight of the composition. Ingredient (F) can be a single polydiorganosiloxane or a combination comprising two or more polydiorganosiloxanes that differ in at least one of the following properties: structure, viscosity, average molecular weight, siloxane units, and sequence. The viscosity of ingredient (F) is not critical and may range from 50 to 1,000 mPa·s at 25 °C. Ingredient (F) may contain at least one aromatic group per molecule, and the aromatic groups are as exemplified above. Ingredient (F) may contain at least 15 mol %, alternatively at least 30 mol % aromatic groups.

Ingredient (F) may comprise an α,ω-dihydroxy-functional polydiorganosiloxane of general formula (VI'): HOR¹²₂SiO-(R¹²₂SiO)ₖ-SiR¹²₂OH, where each R¹² is independently an aromatic group as exemplified above, or a monovalent substituted or unsubstituted hydrocarbon group free of aromatics and free aliphatic unsaturation as exemplified above, with the proviso that on average at least one R¹² per molecule is an aromatic group, and subscript k is an integer with a value of 1 or more. Alternatively, at least one R¹² per molecule is phenyl and k may range from 2 to 8. Alternatively, an organic mold release agent could be used instead of the siloxanes described above.

### Ingredient (G) Optically Active Agent

Ingredient (G) is an optically active agent. Examples of ingredient (G) include optical diffusants, phosphor powders, photonic crystals, quantum dots, carbon nanotubes, dyes such as fluorescent dyes or absorbing dyes, and combinations thereof. The exact amount of ingredient (G) depends on the specific optically active agent selected, however, ingredient (G) may be added in an amount ranging from 0% to 20%, alternatively 1% to 10% based on the weight of the silicone composition. Ingredient (G) may be mixed with the silicone composition or coated on a surface of the optical device prepared by curing the silicone composition to a cured product.

### Ingredient (H) Filler

Ingredient (H) is a filler. Suitable fillers are known in the art and are commercially available. For example, ingredient (H) may comprise an inorganic filler such as silica, e.g., colloidal silica, fumed silica, quartz powder, titanium oxide, glass, alumina, zinc oxide, or a combination thereof. The filler may have an average particle diameter of 50 nanometers or less and does not lower the percent transmittance by scattering or absorption. Alternatively, ingredient (H) may comprise an organic filler such as poly(meth)acrylate resin particles. Ingredient (H) may be added in an amount ranging from 0% to 50%, alternatively 1% to 5% based on the weight of the silicone composition.

The silicone composition described above may be prepared by any convenient means, such as mixing all ingredients at ambient or elevated temperature. The silicone composition may be prepared as a one-part composition or a multiple part composition. A one-part silicone composition can be prepared by mixing ingredients (A), (B), (C), and (D) and any additional ingredients, if present. If a one part silicone composition will be prepared, pot life of the composition may be extended by adding ingredient (E) described above. If the silicone composition will be used in a molding process (or overmolding process), such as that described herein, then ingredient (F) may be added. In a multiple part composition, such as a two part composition, ingredients (C) and (D) are stored in separate parts. For example, a base part may be prepared by mixing ingredients comprising: 60% to 75% ingredient (A), 25% to 40% ingredient (B), and 6 ppm ingredient (D). The base part may optionally further comprise 0.2 to 5 parts ingredient (F), (G), and/or (H). A curing agent part may be prepared by mixing ingredients comprising: 50% to 70% ingredient (A), 20% to 37% ingredient (B), 7% to 16% by weight ingredient (C), and 0.001 to 1% ingredient (E). The curing agent part may optionally further comprise 0.2 to 5 parts ingredient (F), (G), and/or (H). The base part and the curing agent part may be stored in separate containers until just prior to use, when the two parts are mixed together in a ratio of 1 to 10 parts base per 1 part curing agent. These amounts are exemplary (taken from another application).

### Cured Product of the Composition

The cured product of the composition above may be obtained by curing at room temperature or with heating, however heating may accelerate curing. The exact time and temperature for heating will vary depending on various factors including the amount of catalyst and the type and amount of inhibitor present (if any), however curing may be performed by heating at a temperature ranging from 50 °C to 200 °C for an amount of time ranging from several minutes to several hours.

The cured product of the composition described above has improved physical and/or mechanical properties over cured products of compositions known in the art. The cured product of the composition described herein may have a Shore A hardness of at least 30, alternatively Shore A hardness may range from 30 to 80; as measured by ASTM D2240 by the type A durometer. (ASTM D2240 for Shore A durometer corresponds to JIS K 6253 type-A that specifies testing methods for durometer hardness of plastics.) Alternatively, the cured product may have hardness up to 55, alternatively hardness may range from 30 to 55.

The cured product may have a tensile strength of at least 3 MPa, alternatively tensile strength may range from 3 MPa to 14 MPa as measured by ASTM D412. The cured product may have an elongation at break of at least 50%, alternatively elongation at break may range from 50% to 250%, also as measured by ASTM D412. The cured product may exhibit excellent thermo-optic stability, improved mechanical properties, weather resistance and heat resistance. Transmittance is measured on samples initially after cure, then the samples are heated at 150 °C for 1000 hours and transmittance is measured again using a ultraviolet-visible spectrophotometer with medium scanning speed, 1 nanometer slit width to measure yellowing.

### Processes

Optical device components may be prepared using the composition described above by a process comprising: i) shaping the composition and ii) curing the composition to form a cured product for use in an optical device. Step i) may be performed by a process such as injection molding, transfer molding, casting, extrusion, overmolding, compression molding, and cavity molding. The process selected for step i) will depend on various factors including the size and shape of the optical device to be produced and the composition selected.

### Optical Devices

The processes and silicone compositions described above are used to fabricate various optical devices. For example, such optical devices include, but are not limited to CCDs, optical cameras, photo-couplers optical waveguides, lightguides, light sensing elements, and LED packages such HB LED packages., *e.g.,* LED package lenses.

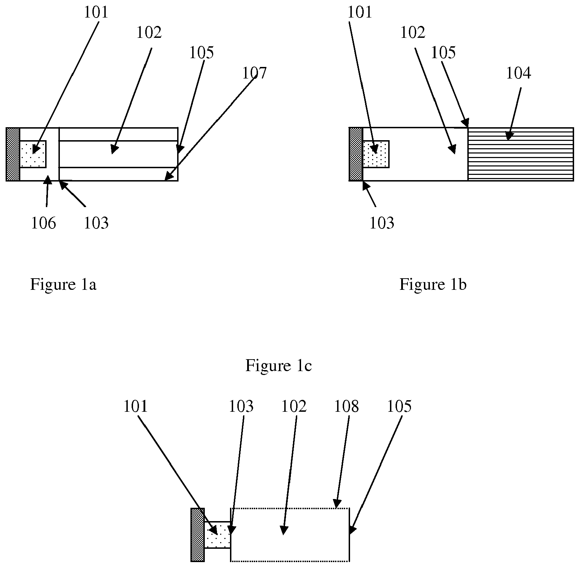

The lightguide prepared using the processes and compositions described above may be fabricated by itself or as part of another device. The device may further comprise a light source, such as an LED or HB LED, coupled to the inlet of the lightguide. The device may further comprise another optical device, such as an organic lightguide or a lens at the outlet of the lightguide. For example, figures 1a, 1b, and 1c show an optical device comprising an LED 101 and a lightguide 102 prepared from a silicone composition described above. The lightguide 102 may be coupled to the LED 101 by simply placing the LED 101 adjacent to the lightguide 102 such that light from the LED 101 enters the inlet 103 of the lightguide 102 as shown in Figure 1a. Any gap between the LED 101 and the inlet 103 of the lightguide 102 may optionally be filled with air or an optical coupling agent 106, such as a gel or elastomer. The lightguide 102 may optionally further comprise a clad 107 surrounding a surface of the lightguide 102. The clad may have an RI lower than the RI of the lightguide 102.

Alternatively, the LED 101 may be integrated with the lightguide 102 such that the silicone composition described above cures to form the lightguide 102 while in contact with the LED 101, as shown in Figure 1b. The optical device may further comprise an organic lightguide 104 coupled to the outlet 105 of the lightguide 102 fabricated from the cured product of the composition. Without wishing to be bound by theory, it is thought that using a lightguide 102 coupled to the LED 101 improves stability of the optical device, while using an organic lightguide 104 coupled to the outlet 105 of the lightguide 102 reduces cost of the resulting optical device because organic lightguides 104, such as PMMA, PC, and COC lightguides may be less expensive to fabricate than the lightguides 102 fabricated from cured products of the composition described above, however, organic lightguides 104 suffer from the drawback of deteriorating when coupled to the LED 101 without a lightguide 102 fabricated from the cured product due to poorer stability of the organic materials of construction as compared to a cured product prepared by curing a composition described herein. Alternatively, the LED 101 may be coupled to the inlet 103 of the lightguide 102 by butt-coupling, as shown in Figure 1c. At least one surface 108 of the lightguide 102 may be treated to affect internal reflection. For example, a surface 108 of the lightguide 102 may be partially or fully mirrored to improve internal reflection. Alternatively, a surface 108 of the lightguide 102 may be partially or fully roughened.

One skilled in the art would recognize that the lightguides shown in figures 1a, 1b, and 1c are exemplary and not limiting. The lightguide may have multiple configurations depending on various factors including the light source to be coupled with the lightguide and the application in which the lightguide will be used. For example, the lightguide may comprise a bar or cylinder shape. The silicone compositions and processes described herein may be used to fabricate the lightguides disclosed, for example, in U.S. Patents 5,594,424; 5,673,995; 6,174,079; 6,568,822; U.S. Published Patent Applications US 2005/0213341 and US 2006/0105485; and PCT Publications WO2005/033207 and WO2006/033375.

The ingredients of the silicone composition described above may be selected such that a lightguide prepared by curing the silicone composition has desired properties for a given application. The lightguide may be used, for example, in backlighting units for displays, vehicle lighting, and message board applications. When the lightguide will be used in these applications, the lightguide may have a hardness as measured by durometer Shore A 50 to 80, alternatively 60 to 80. The lightguide may have an optical clarity greater than 50 %, alternatively 50 % to 100 % in a section having thickness ranging from 1.5 mm to 4 mm. For some automotive headlamp applications, the lightguide may be non-yellowing when exposed to UV radiation. The lightguide may have transmission loss not greater than 20 %, alternatively 15 %, when heated at 150 °C for at least 7 days, alternatively 7 to 60 days (again in a section having thickness ranging from 1.5 mm to 4 mm). The refractive index (RI) of the lightguide may range from 1.4 to 1.46. The RI of the core, if present is less than the RI of the clad. RI may be adjusted by changing amount of aromatic groups (*e.g.,* phenyl) and nonaromatic groups (*e.g.,* methyl) in the ingredients of the composition, which was cured and used to make the lightguide. When an organic lightguide will be coupled, the RI of the lightguide fabricated from cured product of the composition described above may be matched to the RI of the organic lightguide. For example, a PMMA lightguide may have RI 1.49, while a PC lightguide may have RI 1.57.

Alternatively, a molded shape other than a lightguide may be prepared by a molding process, described herein. The molded shape may be, for example, a lens for use in an LED package such as a flat lens, a curved lens, or a fresnel lens.

Alternatively, the silicone composition may be used for packaging optoelectronic devices, such as LED devices. For example, a silicone composition may be molded and cured such that the cured product is formed as a hard lens. The lens may be tack free and resistant to dirt pick up. The composition may be used to form lenses in, for example, an injection molding process such as that disclosed in WO 2005/017995.

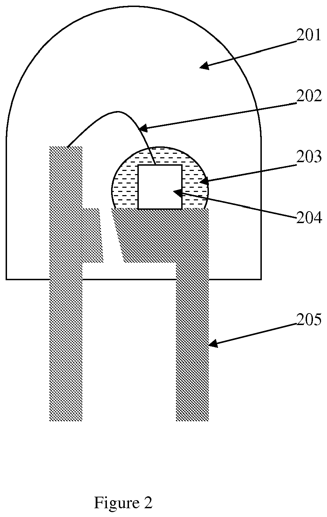

Alternatively, the silicone composition and process may be used to encapsulate an LED device, such as that disclosed in U.S. Patent 6,204,523 or WO 2005/033207. Figure 2 shows a cross section of an LED device with a cured product prepared from the composition described above. The LED device includes an LED chip 204 encapsulated in a soft silicone 203, such as a rubber or gel, or cured product of the silicone composition described above. The LED chip 204 is bonded to lead frame 205 by wire 202. The LED chip 204, wire 202, and soft silicone 203 are surrounded by dome 201, which can be made of a cured product of the silicone composition described above, formulated to have a higher hardness than the soft silicone 203.

### EXAMPLES

These examples are intended to illustrate the invention to one of ordinary skill in the art and should not be interpreted as limiting the scope of the invention set forth in the claims. The following ingredients were used in the examples and comparative examples below. Polymer (A1) was a dimethylvinylsiloxy-terminated polydimethylsiloxane with viscosity 2,000 mPa·s and 0.228% vinyl. Polymer (A2) was a dimethylvinylsiloxy-terminated polydimethylsiloxane with viscosity ranging from 45,000 mPa·s to 65,000 mPa·s and 0.088% vinyl. Polymer (A3) was a dimethylvinylsiloxy-terminated polydimethylsiloxane with a viscosity ranging from 7,000 mPa·s to 12,000 mPa·s and 0.11 to 0.23% vinyl. Resin (B1) was a dimethylvinylated and trimethylated silica prepared by reaction of dimethylvinylchlorosilane and a reaction product of silicic acid, sodium salt, chlorotrimethylsilane, isopropyl alcohol, and water with a vinyl content of 1.95%. Resin (B2) was a dimethylvinylated and trimethylated silica prepared by reaction of dimethylvinylchlorosilane and a reaction product of silicic acid, sodium salt, chlorotrimethylsilane, isopropyl alcohol, and water with a vinyl content of 3.17%. Crosslinker (C1) was trimethylsiloxy-terminated, poly(dimethyl/methylhydrogen)siloxane copolymer with of 5 mm²/s. Crosslinker (C2) was a dimethylhydrogensiloxy-modified silica with a viscosity of 23 mm²/s. Catalyst (D1) was a mixture containing 98 weight parts of a dimethylvinylsiloxy-terminated polydimethylsiloxane with a viscosity ranging from 300 to 600 mPa·s and a vinyl content ranging from 0.38% to 0.60%, 0.2 weight parts of 1,3 diethenyl 1,1,3.3. tetramethyldisiloxane complex with platinum, and 1 weight part tetramethyl tetravinyldisiloxane. Inhibitor (E1) was ethynyl cyclohexanol. Inhibitor (E2) was 3,5-dimethyl-1-hexyn-3-ol.

### Reference Example 1 - Test Methods

Hardness was measured according to ASTM D2240 by the type A durometer. The shore A value was measured three times for each example, and the average was reported for hardness.

Tensile strength and elongation were measured according to ASTM D412. The tensile strength test had a 10 % variance. Each value was measured three times for each example, and the average was reported.

Transmittance is measured on samples initially after cure, then the samples are heated at 150 °C for 1000 hours and transmittance is measured again using a ultraviolet-visible spectrophotometer with medium scanning speed, 1 nanometer slit width to measure yellowing.

### Comparative Examples 1-2 - Compositions Containing One Polymer and Example 1 Containing a Combination of Polymers

The ingredients in Table 1 were combined and cured. The amounts of each ingredient in Table 1 were parts by weight, unless otherwise indicated. The ingredients were combined in a cup and mixed with a dental mixer. The resulting silicone composition was cured by injecting into an optically polished mold and holding in the mold at 130 °C to 180 °C, typically for 1 minute to 5 minutes. The mold formed a tensile bar as described in ASTM D412 for measurement of tensile strength, as described above in Reference Example 1. Hardness and transmittance were measured on each tensile bar before the tensile strength testing. Hardness, tensile strength, elongation, and transmittance were measured according to the method of Reference Example 1. The results are in Table 1.

**Table 1**

| Ingredient | Comparative Example 1 | Comparative Example 2 | Example 1 |
|---|---|---|---|
| Polymer (A1) | 67 | 0 | 33.5 |
| Polymer (A2) | 0 | 71 | 35.5 |
| Resin (B1) | 31 | 27 | 29 |
| Crosslinker (C1) | 5.4 | 4.3 | 4.8 |
| Catalyst (D1) | 3 ppm | 3 ppm | 3 ppm |
| Inhibitor (E1) | 0.01 | 0.01 | 0.01 |
| SiH/Vi ratio | 1.5 | 1.5 | 1.5 |
| % Vi in Resin | 2.0 | 2.0 | 2.0 |
| Hardness | 48 | 42 | 45 |
| Tensile Strength (MPa) | 4.6 | 5.0 | 6.2 |
| Elongation (%) | 52 | 205 | 117 |

Example 1 and comparative examples 1 and 2 show that acceptable hardness and elongation can be achieved using a combination of polymers, and tensile strength unexpectedly increases when the combination of polymers is used, as compared to when either polymer is used alone.

### Comparative Examples 3-4 and Example 2

The ingredients in Table 2 were combined and cured. The amounts of each ingredient in Table 2 were parts by weight, unless otherwise indicated. The ingredients were combined to make the silicone composition and cured to make tensile bars using the same method described above for example 1. Hardness, tensile strength, elongation, and transmittance were measured according to the method described above in Reference Example 1. The results are in Table 2.

**Table 2**

| Ingredient | Comparative Example 3 | Comparative Example 4 | Example 2 |
|---|---|---|---|
| Polymer (A1) | 67 | 0 | 33.5 |
| Polymer (A2) | 0 | 71 | 35.5 |
| Resin (B1) | 31 | 27 | 29 |
| Crosslinker (C2) | 4.1 | 3.3 | 3.7 |
| Catalyst (D1) | 3 ppm | 3 ppm | 3 ppm |
| Inhibitor (E1) | 0.01 | 0 | 0 |
| Inhibitor (E2) | 0 | 0.2 | 0.2 |
| SiH/Vi ratio | 1.5 | 1.5 | 1.5 |
| % Vi in Resin | 2.0 | 1.9 | 2.0 |
| Hardness | 48 | 51 | 51 |
| Tensile Strength (MPa) | 6.7 | 5.3 | 7.3 |
| Elongation (%) | 49 | 197 | 99 |

Example 2 and comparative examples 3 and 4 show that acceptable hardness and elongation can be achieved using a combination of polymers, and tensile strength unexpectedly increases when the combination of polymers is used, as compared to when either polymer is used alone.

### Examples 3-9 and Comparative Examples 5 to 8

The ingredients in Table 3 were combined and cured. The amounts of each ingredient in Table 3 were parts by weight, unless otherwise indicated. The ingredients were combined to make a silicone composition and cured to make tensile bars using the same method described above for example 1. Hardness, tensile strength, elongation, and transmittance were measured according to the method described above in Reference Example 1. The results are in Table 3. Examples 3-9 show that cured products with desirable combinations of properties can be prepared using a range of vinyl contents in the silicone resin and different combinations of low viscosity and high viscosity polymers.

Comparative examples 5-7 show that when a resin with too high vinyl content is used, the product has high hardness, which may make it undesirable for certain applications, such as overmolding. Example 1 has better (lower) hardness and better (higher) elongation than comparative example 5. Comparative example 6 has lower tensile strength and elongation, as well as higher hardness, than example 2 even though the crosslinker is the same. Example 2 has better (lower) hardness and better (higher) elongation than either comparative examples 6 and 7. Comparative example 8 shows that when two low viscosity polymers are used instead of a combination of a low viscosity polymer and a high viscosity polymer, elongation was detrimentally affected in this cured product, so the beneficial combination of properties was not achieved.

**Table 4**

| Ingredient | Example 3 | Example 4 | Example 5 | Example 6 | Example 7 | Example 8 | Example 9 | Comparative Example 5 * | Comparative Example 6 | Comparative Example 7 | Comparative Example 8 |
|---|---|---|---|---|---|---|---|---|---|---|---|
| Polymer (A1) low viscosity | 0 | 0 | 0 | 22 | 0 | 33.5 | 22.1 | 0 | 0 | 0 | 33.5 |
| Polymer (A3) low viscosity | 41.3 | 31 | 31 | 21 | 50 | 0 | 20.5 | 62 | 62 | 59 | 31 |
| Polymer (A2) high viscosity | 17.8 | 35.5 | 35.5 | 23 | 13 | 31 | 23.4 | 0 | 0 | 0 | 0 |
| Resin (B1) | 40.5 | 13.5 | 13.5 | 19 | 5.4 | 15.5 | 19.1 | 0 | 0 | 0 | 15.5 |
| Resin (B2) | 0 | 18.5 | 18.5 | 12 | 30 | 18.5 | 12.2 | 37 | 37 | 41 | 18.5 |
| Crosslinker (C1) | 0 | 6.5 | 0 | 0 | 0 | 7.1 | 6 | 8.9 | 0 | 1 | 0 |
| Crosslinker (C2) | 4.6 | 0 | 5.3 | 4.9 | 6.3 | 0 | 0 | 0 | 7.3 | 10.7 | 5.7 |
| Catalyst (D1) | 3 ppm | 3 ppm | 3 ppm | 3 ppm | 3 ppm | 3 ppm | 3 ppm | 3 ppm | 3 ppm | 3 ppm | 3 ppm |
| Inhibitor (E1) | 0 | 0.01 | 0.01 | 0 | 0 | 0.01 | 0.01 | 0.01 | 0.01 | 0.01 | 0.01 |
| Inhibitor (E2) | 0.2 | 0 | 0 | 0.2 | 0.2 | 0 | 0 | 0 | 0 | 0 | 0 |
| SiH/Vi ratio | 1.4 | 1.5 | 1.5 | 1.5 | 1.5 | 1.5 | 1.5 | 1.5 | 1.5 | 1.6 | 1.5 |
| % Vi in Resin | 1.95 | 2.7 | 2.7 | 2.4 | 3.0 | 2.5 | 2.4 | 3.2 | 3.2 | 4 | 2.5 |
| Hardness | 74 | 61 | 71 | 70 | 79 | 65 | 59 | 70 | 86 | 88 | 75 |
| Tensile Strength (MPa) | 11.6 | 6.8 | 8.7 | 9.0 | 10.7 | 10.1 | 8.1 | 2.3 | 3.3 | 10.4 | 9.1 |
| Elongation (%) | 82 | 207 | 69 | 81 | 60 | 92 | 140 | 12 | 3 | 44 | 42 |

| | | | | | | | | | | | |
|---|---|---|---|---|---|---|---|---|---|---|---|
| * The cured product prepared in comparative example 5 was bottle. | | | | | | | | | | | |

### Industrial Applicability

Compositions are useful for fabrication of optical devices such as lightguides and LED packages. Cured products of the composition such as silicone encapsulants prepared by curing these compositions may provide the benefits of enhanced light transmission, enhanced reliability, and increased lifetimes of LED packages. Silicone encapsulants may exhibit superior performance over epoxy encapsulants in temperature and humidity resistance in LED applications. The compositions and processes may be used to prepare cured products having geometries including, but not limited to, cylindrical, rectangular, simple convex lenses, patterned lenses, textured surfaces, domes, and caps. In optical device applications the encapsulants may be pre-manufactured by molding (injection or transfer) or casting processes. Alternatively, a process for molding over an optical device assembly, called 'overmolding' or "insert molding" on a rigid or flexible substrate may also be performed using the composition described herein. The composition forms a cured product that is tough (has high tensile strength). The composition can be formulated to produce a cured product having a relatively high, or a relatively low hardness, depending on the desired end use of the cured product. The surface of the cured product is not sticky, and has an elastoplastic character. This combination of properties makes the composition suitable for overmolding as well as other applications. The lightguide described above may be used to transmit light from a light source to a viewing surface by internal reflection. Such applications include backlighting units for displays, vehicle lighting, and message board applications.

## Claims

1. Use of a cured product of a composition in an optical device application, where the composition comprises:
(A) a polymer combination comprising
(A1) a low viscosity polydiorganosiloxane having an average of at least two aliphatically unsaturated organic groups per molecule and having a viscosity of up to 12,000 mPa·s, and
(A2) a high viscosity polydiorganosiloxane having an average of at least two aliphatically unsaturated organic groups per molecule and having a viscosity of at least 45,000 mPa·s;
(B) a silicone resin having an average of at least two aliphatically unsaturated organic groups per molecule, a vinyl content of up to 3.0% by weight; based on the weight of the silicone resin
(C) a crosslinker having an average, per molecule, of at least two silicon bonded hydrogen atoms; and
(D) a hydrosilylation catalyst;
with the proviso that when ingredients comprising (A), (B), and (C) and their amounts in the composition are selected such that a ratio of a total amount of silicon bonded hydrogen atoms in the composition/ a total amount of aliphatically unsaturated organic groups in the composition ranges from 1.2 to 1.7, the cured product has Shore A hardness of at least 30, tensile strength of at least 3 MPa, and elongation at break of at least 50%, the hardness being measured according to ASTM D2240 and the tensile strength being measured according to ASTM D412.

2. Use of a cured product of a composition in an optical device selected from:
charged coupled devices, light emitting diodes, lightguides (102), optical cameras, photo-couplers, and waveguides, where the composition is defined in Claim 1.

3. Use as claimed in claim 1 or claim 2, where ingredient (A1) has a viscosity ranging from 300 mPa·s to 2,000 mPa·s, and ingredient (A2) has a viscosity ranging from 45,000 to 65,000 mPa·s.

4. Use as claimed in claim 1 or claim 2, where ingredient (B) has a vinyl content ranging from 1.5% to 3.0% by weight based on the weight of the silicone resin

5. Use as claimed in claim 1 or claim 2, where ingredient (A1) is present in an amount ranging from 10% to 90% by weight based on combined weight of ingredient (A), and ingredient (A2) is present in an amount ranging from 10% to 90% by weight based on the combined weight of ingredient (A).

6. Use as claimed in claim 1 or claim 2, where ingredient (B) is present in an amount ranging from 25 % to 40% by weight of the silicone composition.

7. Use as claimed in claim 1 or claim 2, where ingredient (C) is present in an amount sufficient to provide the SiH/Vi ratio in the silicone composition.

8. Use as claimed in claim 1 or claim 2, where ingredient (D) is present in an amount sufficient to provide 0.1 ppm to 1,000 ppm of platinum group metal based on the weight of the silicone composition.

9. Use as claimed in claim 1 or claim 2, further comprising an additional ingredient selected from the group consisting of (E) an inhibitor, (F) a mold release agent, (G) an optically active agent, (H) a filler, (I) an adhesion promoter, (J) a heat stabilizer, (K) a flame retardant, (L) a reactive diluent, (M) a pigment, (N) a flame retarder, (O) an oxidation inhibitor, and a combination thereof.

10. Use as claimed in claim 1 or claim 2, where the cured product has Shore A hardness ranging from 30 to 800.

11. Use as claimed in claim 1 or claim 2,, where the cured product has tensile strength ranging from 3 to 14 MPa.

12. Use as claimed in claim 1 or claim 2,, where the cured product has elongation at break ranging from 50% to 250%.

## Patentansprüche

1. Verwendung eines gehärteten Produkts einer Zusammensetzung in einer Anwendung einer optischen Vorrichtung, wobei die Zusammensetzung Folgendes umfasst:
(A) eine Polymerkombination, umfassend
(A1) ein Polydiorganosiloxan niedriger Viskosität mit durchschnittlich mindestens zwei aliphatisch ungesättigten organischen Gruppen pro Molekül und einer Viskosität von bis zu 12.000 mPa.s und
(A2) ein Polydiorganosiloxan hoher Viskosität mit durchschnittlich mindestens zwei aliphatisch ungesättigten organischen Gruppen pro Molekül und einer Viskosität von mindestens 45.000 mPa.s;
(B) ein Silikonharz mit durchschnittlich mindestens zwei aliphatisch ungesättigten organischen Gruppen pro Molekül und einem Vinylgehalt von bis zu 3,0 Gew.-%;
basierend auf dem Gewicht des Silikonharzes,
(C) ein Vernetzungsmittel mit durchschnittlich mindestens zwei siliciumgebundenen Wasserstoffatomen pro Molekül; und
(D) einen Hydrosilylierungskatalysator;
mit der Maßgabe, dass dann, wenn die Bestandteile, die (A), (B) und (C) umfassen, und deren Mengen in der Zusammensetzung derart ausgewählt sind, dass ein Verhältnis einer Gesamtmenge von siliciumgebundenen Wasserstoffatomen in der Zusammensetzung/einer Gesamtmenge von aliphatisch ungesättigten organischen Gruppen in der Zusammensetzung im Bereich von 1,2 bis 1,7 liegt, das gehärtete Produkt eine Shore-A-Härte von mindestens 30, eine Zugfestigkeit von mindestens 3 MPa und eine Bruchdehnung von mindestens 50 % aufweist, wobei die Härte gemäß ASTM D2240 und die Zugfestigkeit gemäß ASTM D412 gemessen wird.

2. Verwendung eines gehärteten Produkts einer Zusammensetzung in einer optischen Vorrichtung, die ausgewählt ist aus:
geladenen gekoppelten Vorrichtungen, lichtemittierenden Dioden, Lichtwellenleitern (102), optischen Kameras, Optokupplern und Wellenleitern, wobei die Zusammensetzung vorliegt, wie in Anspruch 1 definiert.

3. Verwendung nach Anspruch 1 oder Anspruch 2, wobei Bestandteil (A1) eine Viskosität im Bereich von 300 mPa.s bis 2.000 mPa.s aufweist und Bestandteil (A2) eine Viskosität im Bereich von 45.000 bis 65.000 mPa.s aufweist.

4. Verwendung nach Anspruch 1 oder Anspruch 2, wobei Bestandteil (B) einen Vinylgehalt im Bereich von 1,5 Gew.-% bis 3,0 Gew.-%, basierend auf dem Gewicht des Silikonharzes, aufweist.

5. Verwendung nach Anspruch 1 oder Anspruch 2, wobei Bestandteil (A1) in einer Menge im Bereich von 10 Gew.-% bis 90 Gew.-%, basierend auf dem kombinierten Gewicht von Bestandteil (A), vorhanden ist und Bestandteil (A2) in einer Menge im Bereich von 10 Gew.-% bis 90 Gew.-%, basierend auf dem kombinierten Gewicht von Bestandteil (A), vorhanden ist.

6. Verwendung nach Anspruch 1 oder Anspruch 2, wobei Bestandteil (B) in einer Menge im Bereich von 25 Gew.-% bis 40 Gew.-% der Silikonzusammensetzung vorhanden ist.

7. Verwendung nach Anspruch 1 oder Anspruch 2, wobei Bestandteil (C) in einer Menge vorhanden ist, die ausreicht, um das SiH/Vi-Verhältnis in der Silikonzusammensetzung bereitzustellen.

8. Verwendung nach Anspruch 1 oder Anspruch 2, wobei Bestandteil (D) in einer Menge vorhanden ist, die ausreicht, um 0,1 ppm bis 1.000 ppm Platingruppenmetall, basierend auf dem Gewicht der Silikonzusammensetzung, bereitzustellen.

9. Verwendung nach Anspruch 1 oder Anspruch 2, ferner umfassend einen zusätzlichen Bestandteil, ausgewählt aus der Gruppe bestehend aus (E) einem Inhibitor, (F) einem Formtrennmittel, (G) einem optisch aktiven Mittel, (H) einem Füllmittel, (I) einem Adhäsionspromotor, (J) einem Wärmestabilisator, (K) einem Flammenhemmstoff, (L) einem reaktiven Verdünnungsmittel, (M) einem Pigment, (N) einem Flammverzögerungsmittel, (O) einem Oxidationsinhibitor und einer Kombination davon.

10. Verwendung nach Anspruch 1 oder Anspruch 2, wobei das gehärtete Produkt eine Shore-A-Härte im Bereich von 30 bis 800 aufweist.

11. Verwendung nach Anspruch 1 oder Anspruch 2, wobei das gehärtete Produkt eine Zugfestigkeit im Bereich von 3 bis 14 MPa aufweist.

12. Verwendung nach Anspruch 1 oder Anspruch 2, wobei das gehärtete Produkt eine Bruchdehnung im Bereich von 50 % bis 250 % aufweist.

## Revendications

1. Utilisation d'un produit durci d'une composition dans une application de dispositif optique, où la composition comprend :
(A) une combinaison de polymères comprenant
(A1) un polydiorganosiloxane à faible viscosité ayant une moyenne d'au moins deux groupes organiques à insaturation aliphatique par molécule et ayant une viscosité allant jusqu'à 12 000 mPa·s, et
(A2) un polydiorganosiloxane à haute viscosité ayant une moyenne d'au moins deux groupes organiques à insaturation aliphatique par molécule et ayant une viscosité d'au moins 45 000 mPa.s ;
(B) une résine de silicone ayant une moyenne d'au moins deux groupes organiques à insaturation aliphatique par molécule, une teneur en vinyle allant jusqu'à 3,0 % en poids ;
sur base du poids de la résine de silicone
(C) un agent de réticulation ayant une moyenne, par molécule, d'au moins deux atomes d'hydrogène liés à du silicium ; et
(D) un catalyseur d'hydrosilylation ;
à condition que, lorsque les ingrédients comprenant (A), (B) et (C) et leurs quantités dans la composition sont choisis de telle sorte qu'un rapport d'une quantité totale d'atomes d'hydrogène liés à du silicium dans la composition/ une quantité totale de groupes organiques à insaturation aliphatique dans la composition va de 1,2 à 1,7, le produit durci a une dureté Shore A d'au moins 30, une résistance à la traction d'au moins 3 MPa, et un allongement à la rupture d'au moins 50 %, la dureté étant mesurée selon ASTM D2240 et la résistance à la traction étant mesurée selon ASTM D412.

2. Utilisation d'un produit durci d'une composition dans un dispositif optique choisi parmi :
des dispositifs à couplage de charge, des diodes électroluminescentes, des guides lumineux (102), des caméras optiques, des photocoupleurs et des guides d'ondes, où la composition est définie dans la revendication 1.

3. Utilisation selon la revendication 1 ou la revendication 2, où l'ingrédient (A1) a une viscosité allant de 300 mPa.s à 2000 mPa·s, et l'ingrédient (A2) a une viscosité allant de 45 000 à 65 000 mPa·s.

4. Utilisation selon la revendication 1 ou la revendication 2, où l'ingrédient (B) a une teneur en vinyle allant de 1,5 % à 3,0 % en poids sur base du poids de la résine de silicone.

5. Utilisation selon la revendication 1 ou la revendication 2, où l'ingrédient (A1) est présent en une quantité allant de 10 % à 90 % en poids sur base du poids combiné de l'ingrédient (A), et l'ingrédient (A2) est présent en une quantité allant de 10 % à 90 % en poids sur base du poids combiné de l'ingrédient (A).

6. Utilisation selon la revendication 1 ou la revendication 2, où l'ingrédient (B) est présent en une quantité allant de 25 % à 40 % en poids de la composition de silicone.

7. Utilisation selon la revendication 1 ou la revendication 2, où l'ingrédient (C) est présent en une quantité suffisante pour fournir le rapport SiH/Vi dans la composition de silicone.

8. Utilisation selon la revendication 1 ou la revendication 2, où l'ingrédient (D) est présent en une quantité suffisante pour fournir 0,1 ppm à 1000 ppm de métal du groupe du platine sur base du poids de la composition de silicone.

9. Utilisation selon la revendication 1 ou la revendication 2, comprenant en outre un ingrédient additionnel choisi dans le groupe constitué de (E) un inhibiteur, (F) un agent de démoulage, (G) un agent optiquement actif, (H) une charge, (I) un promoteur d'adhésion, (J) un agent stabilisant thermique, (K) un ignifugeant, (L) un diluant réactif, (M) un pigment, (N) un matériau d'ignifugation, (O) un inhibiteur d'oxydation, et une combinaison de ceux-ci.

10. Utilisation selon la revendication 1 ou la revendication 2, où le produit durci a une dureté Shore A allant de 30 à 800.

11. Utilisation selon la revendication 1 ou la revendication 2, où le produit durci a une résistance à la traction allant de 3 à 14 MPa.

12. Utilisation selon la revendication 1 ou la revendication 2, où le produit durci a un allongement à la rupture allant de 50 % à 250 %.
